(19) **Europäisches Patentamt**

**European Patent Office**

**Office européen des brevets**

(11) Veröffentlichungsnummer: **0 030 640**
**B1**

(12) **EUROPÄISCHE PATENTSCHRIFT**

(45) Veröffentlichungstag der Patentschrift: **25.05.88**

(21) Anmeldenummer: **80107215.8**

(22) Anmeldetag: **20.11.80**

(51) Int. Cl.⁴: **H 01 L 21/28, H 01 L 21/306**

(54) **Verfahren zum Anbringen einer selbstausrichtenden Gateelektrode in einem V-Metalloxid-Feldeffekttransistor.**

(30) Priorität: **17.12.79 US 103981**

(43) Veröffentlichungstag der Anmeldung:
**24.06.81 Patentblatt 81/25**

(45) Bekanntmachung des Hinweises auf die
Patenterteilung:
**25.05.88 Patentblatt 88/21**

(84) Benannte Vertragsstaaten:
**DE FR GB IT**

(56) Entgegenhaltungen:
**US-A-4 105 475**

**PROCEEDINGS OF THE 8th CONFERENCE (1976 INTERNATIONAL) ON SOLID STATE DEVICES, TOKYO, 1976; JAPANESE JOURNAL OF APPLIED PHYSICS, Band 16, 1977, Supplement 16-1, Seiten 179-183; S. NISHIMATSU : "Grooved gate MOSFET" Idem**

(73) Patentinhaber: **International Business Machines Corporation**
**Old Orchard Road**
**Armonk, N.Y. 10504 (US)**

(72) Erfinder: **Garnache, Richard Raymond**
**1400 Spear Street**
**South Burlington Vermont 05401 (US)**
Erfinder: **Kenney, Donald McAlpine**
**RFD 2**
**Shelburne Vermont 05482 (US)**

(74) Vertreter: **Schröder, Otto H., Dr. Ing.**
**IBM Corporation Säumerstrasse 4**
**CH-8803 Rüschlikon (CH)**

(56) Entgegenhaltungen:

**IEEE TRANSACTIONS ON ELECTRON DEVICES, Band ED-25, Nr. 10, Oktober 1978, Seiten 1229-1234, IEEE, New York, US; K.P. LISIAK: "Optimization of nonplanar power MOS transistors"**

Courier Press, Leamington Spa, England.

## Beschreibung

Die Erfindung betrifft ein Verfahren zum Herstellen einer leitenden Elektrode für eine Halbleitervorrichtung mit einem Substrat in dessen einer Oberfläche mindestens eine Vertiefung angebracht ist.

Seit vielen Jahren sind seit Beginn der Entwicklung von integrierten Schaltungen große Anstrengungen unternommen worden, um eine immer größere Anzahl von Bauelementen und ihre zugeordneten Funktionen auf einen einzigen, mit integrierten Schaltungen versehenen Halbleiterplättchen unterzubringen. Verfahren, mit deren Hilfe die Dichte der Bauelemente auf dem Halbleiterplättchen erhöht werden konnten, haben immer in der Halbleiterindustrie große Aufmerksamkeit gefunden. Eine kürzlich, zur Erhöhung der Schaltungsdichte, eingeführte Technik verwendet in die Oberfläche des Halbleitersubstrates eingeätzte Vertiefungen zur Herstellung von Halbleiterbauelementen mit vertikaler Orientierung, wodurch die für die Anordnung der einzelnen Bauelemente erforderliche Fläche nach den Seiten hin verringert wird.

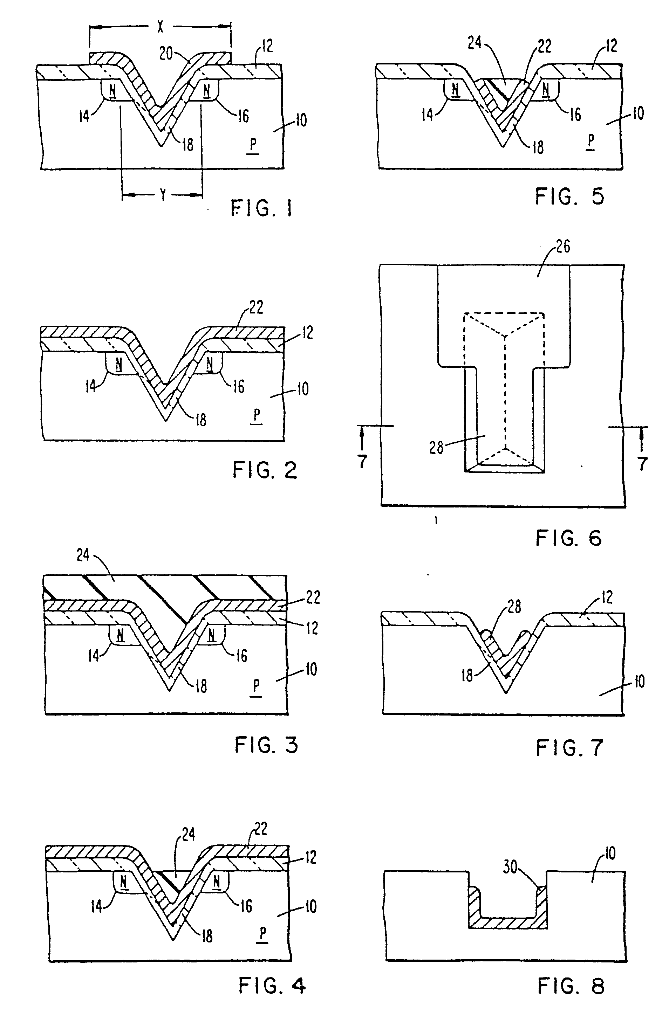

Obwohl die Verwendung von in vertikaler Richtung arbeitenden Transistoren bereits durch Shockley, 1956 in der US-Patentschrift 2 980 830 vorgeschlagen worden war, ergaben sich jedoch erst kürzlich durch die zur Verfügung stehenden photolithographischen Verfahren unüberwindbare Grenzen für noch größere Verbesserungen in der Dichte von konventionellen, planaren, integrierten Schaltungen. Vertikale Integrationstechniken, insbesondere beim Entwurf, von mit Metalloxid-Halbleiter-Feldeffekttransistoren (MOSFET) arbeitenden logischen Schaltungen, ergeben wünschenswerte Zunahmen in der Schaltungsdichte. Dies geht beispielsweise aus einem Aufsatz von F. B. Jenne, in *Electronics,* August 18, 1977, Seiten 100 bis 106, mit dem Titel, "Grooves Add New Dimension to V—MOS Structures and Performance" hervor. Weitere Verbesserungen in der Schaltungsdichte in der V—MOS Technik unter Verwendung bisher bekannter photolithographischer Verfahren werden außerdem durch die in Fig. 1 zum Stand der Technik dargestellten Ausrichttoleranzen begrenzt.

In Fig. 1 ist ein V—MOSFET mit einem Halbleitersubstrat 10 aus P-leitendem Material gezeigt, auf dessen oberer Oberfläche eine relativ dicke thermische Oxidschicht 12 aufgewachsen ist. In diese Oxidschicht 12 ist eine rechteckige Öffnung mit der Breite Y eingeätzt, die damit die Oberfläche des Substrates 10 freilegt. Ein N-leitendes Störelement, wie z. B. Arsen oder Phosphor, wird dann durch diese Öffnung in das Substrat eindiffundiert und bildet eine hochdotierte N-leitende Zone. Anschließend wird jede die N-leitende Zone überdeckende Oxidschicht entfernt, und eine V-förmige Nut oder Vertiefung wird anisotrop in das Substrat 10 eingeätzt. Wenn man die Substratoberfläche parallel zur 100 Ebene des Kristalls wählt, dann ätzen bekannte anisotrope Ätzflüssigkeiten vorzugsweise längs der Richtung 111 und bilden eine selbstbrenzende V-förmige Nut. Wegen der seitlichen Diffusion des N-leitenden Störelements verbleiben Teile der ursprünglich N-leitenden Zone als Zonen 14 und 16, die anschließend als Source- und Drainzone des V—MOSFET dienen. Als nächstes wird eine dünne Gate-Isolierschicht 18 in der V-förmigen Nut aufgewachsen. Bis zu diesem Punkt kann dieses Verfahren nur mit einer einzigen Photolackschicht und zugeordneter Maske durchgeführt werden, da sowohl Sourcezone, Drainzone und V-förmige Nut in selbstausrichtender Weise durch einen einzigen Photolithographischen Ätzschritt hergestellt werden können, der zur Bildung der Öffnung in der dicken Oxidschicht 12 benutzt worden war. Durch Verwendung dieser kleinsten Maskengeometrie wurde ein sehr kleines Bauelement zum Teil definiert. Um jedoch den V—MOSFET fertigzustellen ist noch eine Gateelektrode 20 erforderlich, die durch einen zweiten photolithographischen Maskenschritt definiert werden muß. Für die richtige Ausrichtung der Gateelektrode ist es normalerweise notwendig, alle möglichen Ausrichttoleranzen für die Maske zu berücksichtigen, die zwischen der Ausrichtung der Maske für die Bildung der Gateelektrode und der zuvor verwendeten Maske zur Definition der übrigen Teile des FET auftreten können. In einenm Verfahren mit einem Maskenausrichtfehler von ±d, muß für die ordnungsgemäße Herstellung der Gateelektrode die kleinste Maskenabmessung x für Gateelektrode gleich y + 2d sein. D. h. aber, daß die gesamte kleinste Abmessung in seitlicher Richtung y + 2d wird, obgleich ein wesentlicher Teil des V—MOSFET unter Verwendung der kleinsten photolithographischen Abmessung y hergestellt wurde. Eine Technik, durch die bei einem solchen Verfahren eine selbstausgerichtete Gateelektrode erzeugt werden könnte, würde zu einer weiteren Erhöhung der Schaltungsdichte führen. Bisher bekannte Verfahren zur Bildung einer selbstausgerichteten Elektrode innerhalb einer Vertiefung, wie z. B. einer V-förmigen Nut haben alle unübersehbare Nachteile.

Ein bekanntes Verfahren zur Bildung einer selbstausgerichteten Elektrode in einer Vertiefung ist aus einem Artikel von P. Geldermans in *IBM Technical Disclosure Bulletin,* Band 19, Nr. 10, März 1977, Seiten 3957 bis 3958, mit dem Titel "Making Conductive Platinum Membranes Across Holes in Silicon without the Use of Masks", beschrieben. Hier wird eine dünne leitende Schicht über einem Substrat niedergeschlagen, das auf seiner Oberfläche mit Ausnahme der Stelle, an der die Vertiefung angebracht werden soll, eine selektiv ätzbare Schicht aufweist. Nach Niederschlag der leitenden Schicht wird die ätzbare Schicht entfernt, so daß die darüber liegende leitende Schicht an den Kanten der Vertiefung unterbrochen wird, so daß die leitende Schicht nur in der Vertiefung verbleibt. Die Verwendung derartiger Ablöseverfahren hängt in hohem Maße von den physikalischen Eigenschaften der niedergeschlagenen leitenden Schicht ab und hatte, wie festgestellt wurde, auch noch andere unerwünschte Verfahrensbeschränkungen.

Ein anderes, in der US-Patentschrift 3 998 673 offenbartes Verfahren zeigt die Herstellung einer selbstausgerichteten, massiven, dreieckförmigen Elektrode in einer anisotrop geätzten V-förmigen Nut durch Niederschlagen einer dicken Schicht eines polykristallinen Halbleitermaterials (Polysilicium), das die V-förmige Vertiefung vollkommen ausfüllt und die Oberfläche des Substrats bedeckt. Überschüssiges Polysilicium und die schützende Oberflächenoxidschicht werden dadurch entfernt, daß diese Flächen mit der Oberfläche des Substrats abgeschliffen und poliert werden, so daß man innerhalb der ursprünglichen Substratoberfläche eine dreieckförmige Polysiliciumzone erhält. Die Steuerung des Schleifverfahrens ist außerordentlich schwierig, und das Verfahren ergibt eine massive Polysiliciumschicht, die für V—MOSFET Anwendungen unerwünscht sein kann.

In einem Aufsatz "Optimization of Nonplanar Power MOS Transistors", von K. P. Lisiak u.a., in *IEEE Transactions on Electron Devices,* Band ED—25, Nr. 10, Oktober 1978, Seiten 1229 bis 1234, wird ein ähnliches Verfahren offensichtlich benutzt, jedoch nicht im einzelnen beschrieben. Dort ist in Fig. 7 (d) eine selbstausgerichtete Gateelektrode für einen V—MOSFET gezeigt, die offensichtlich durch Abschleifen der Oberfläche des teilweise fertiggestellen Transistors zum Einebnen der oberen Kante der Gateelektrode mit der Oberfläche des Substrats erzeugt worden ist.

Eine ähnlich erzeugte Polysiliciumstruktur und ein zugehöriges Verfahren, werden in der US-Patentschrift 4 120 744 offenbart. Hier wird eine dreieckige Polysiliciumzone in einer oxidierten V-förmigen Vertiefung dadurch erzeugt, daß selektiv eine über den V-förmigen Vertiefungen und dem Substrat liegende dicke Polysiliciumschicht selektiv bis auf eine Ebene unterhalb der Oberfläche des Substrats abgeätzt wird. In den in Fign. 9 bis 19 dargestellten weiteren Verfahren, wird eine dünne Polysiliciumschicht über einer durch ein Oxid geschützten Oberfläche aufgebracht, die V-förmige Vertiefungen enthält. Nach Aufbringen der dünnen Oxidschicht über der Polysiliciumschicht wird eine Schicht aus Photolack aufgebracht, die dann so in ein Munster umgeformt wird, daß eine dünne Schicht aus Photolack über einem Teil der Polysiliciumschicht völlig innerhalb der durch Oxidschicht bedeckten V-förmigen Vertiefungen liegt. Dann werden die freiliegende Oxidschicht und die Polysiliciumschicht selektiv abgeätzt, so daß die durch Photolack geschützte Siliciumdioxid- und Polysiliciumschicht innerhalb der V-förmigen Vertiefungen zurückbleiben. Dieses letztegenannte Verfahren ist schwierig durchzuführen, da die für die Belichtung des Photolacks erforderliche Maske, die nicht beschrieben ist, mit den vertieften Abschnitten der V-förmigen Vertiefungen ausgerichtet sein muß. Dieses Verfahren erfordert zwingend, daß die V-förmigen Vertiefungen unter Verwendung einer Maske hergestellt werden, bei denen die Öffnungen für die V-förmigen Vertiefungen wesentlich größer sein müssen, als die kleinsten photolithographischen Abmessungen.

Auch in einem Artikel "Grooved Gate MOSFET" von S. Nishimatsu u.a., im Japanese Journal of Applied Physics, Band 16, 1977, Suppl. 16—1, Seiten 179 bis 183, wird ein Verfahren zur Herstellung eines, eine geätzte V-förmige Nut aufweisenden Halbleiterelements beschrieben. Wie in den anderen bisher bekannt gewordenen Verfahren findet sich auch hier kein Hinweis auf das der vorliegenden Erfingung zugrunde liegende Zwei-Masken-Verfahren.

Weitere Veröffentlichungen, die eine gewisse Beziehung zu der vorliegenden Erfindung haben, sollen anschließend noch aufgeführt werden. Der Aufsatz von R. R. Garnache, in *IBM Technical Disclosure Bulletin,* Band 19, Nr. 7, Dezember 1976, Seiten 2471 bis 2472, mit dem Titel "Method for Forming Phase Lines", offenbart die selektive Ätzung von erhabenen Abschnitten leitender aus Polysilicium bestehender Linien, die über eine wellige Substratoberfläche verlaufen, durch Anbringen einer relativ dicken Photolackschicht über dem Substrat, durch Ionenimplantation von den Leitungstyp bestimmenden Störelementen bis zu einer solchen Tiefe, die ausreicht, die Dicke nur der erhabenen Abschnitte der Polysiliciumleitungen zu durchdringen, entfernen der Photolackschicht und selektives Ätzen dieser erhabenen Abschnitte der Polysiliciumschicht und nicht der nicht mit Ionen implantierten Abschnitte, so däß die Polysiliciumleitungen nur in denjeniger Bereichen des Substrats gebildet werden, die ursprünglich nicht erhaben waren. Der Aufsatz "Forming Sidewall Dielectric Isolation of Integrated Circuit Devices" von P. M. Schaible u.a., in *IBM Technical Disclosure* Bulletin, Band 17, Nr. 10, März 1975, Seiten 2893 und 2894, ist hier von Interesse, da dort die Verwendung von reaktivem Ionenätzen für eine dicke organische Polymerschicht angegeben ist, die über einem Substrat liegt, das V-förmige Vertiefungen enthält, um dadurch die Oberfläche des Substrats einzuebnen, so daß mit Polymerem gefüllte V-förmige Vertiefungen übrigbleiben.

Der Aufsatz von G. T. Galyon, in *IBM Technical Disclosure Bulletin,* Band 18, Nr. 6, November 1975, Seite 1854 mit dem Titel "Isolation of Device Components" ist hier ebenfalls von Interesse, da dort ein Verfahren zur Bildung von dielektrisch isolierten Zonen in einem Halbleitersubstrat offenbart ist, bei der ein Photolack eine in dem Substrat eingeätzte Vertiefung nur teilweise ausfüllt. Dort ist jedoch kein Verfahren offenbart, wie eine solche Struktur erzielbar ist. Schließlich sei noch die US—Patentschrift 4 163 988 zu erwähnen, die V—MOSFET Elemente zeigt, die leitende Polysiliciumelektroden aufweisen, die innerhalb einer V-förmigen Nut unterhalb der Oberfläche eines Substrats endigen, wobei jedoch nicht angegeben ist, wie eine derartige Struktur gebildet werden kann.

Die der Erfindung zugrundeliegende Aufgabe kann also darin gesehen werden, ein Verfahren anzugeben, bei dem die Schaltungsdichte einer integrierten Schaltung in V—MOS Transistortechnik noch weiter erhöht werden kann insbesondere durch die Erzeugung selbstrausrichtender Gateelektroden für die V—MOS Technik.

Kurz gesagt läßt sich dies dadurch erreichen, daß in der Oberfläche eines Halbleitersubstrats Vertiefungen für die Herstellung von mit V-förmiger Nut versehenen Halbleiterbauelementen und anderen Bauelementen hergestellt werden. Nach einigen Verfahrensschritten, die sich auf die jeweils herzustellende bestimmte, eine V-förmige Vertiefung aufweisende Vorrichtung bezieht, wird eine Schicht aus einem leitenden Material, das sich zur Bildung einer Elektrodenschicht eignet, niedergeschlagen. Die Oberfläche dieses teilweise bearbeiteten Substrats wird dann mit einem maskenbildenden Material, wie z. B. einem Photolack oder einem anderen, normalerweise bei der Herstellung von Halbleitervorrichtungen verwendeten polymeren Material überzogen. Dabei wird dieses organische Material derart aufgebracht, daß die außen liegende Oberfläche im wesentlichen eben ist. Eine selektive Materialätzung wird dann so lange durchgeführt, bis das organische Material nur mehr in den mit leitendem Material überzogenen V-förmigen Vertiefungen verbliebt. Das verbleibende organische Material wird dann als Ätzmaske für die Ätzung der freiliegenden Teile der leitenden Schicht verwendet. Nach Abziehen des restlichen organischen Materials von dem Substrat erhält man eine selbstausgerichtete leitende Schicht innerhalb der V-förmigen Vertiefungen mit einer seitlichen Abmessung, die kleiner ist, als die Oberseite der V-förmigen Vertiefung. Gemäß der vorliegenden Erfindung wird durch Verwendung unkritischer, zusätzlicher Sperrmasken die Definition der leitenden Schicht auch in Bereichen des Substrats außerhalb der V-förmigen Vertiefungen eingesetzt.

Die Erfindung wird nunmehr anhand der beigefügten Zeichnungen im einzelnen beschrieben.

In den Zeichnungen zeigt

Fig. 1 eine Querschnittsansicht eines mit einer V-förmigen Nut versehenen MOSFET, mit einer Gateelektrodenstruktur, wie sie für den Stand der Technik typisch ist, und die hier erforderliche Breite X der Gateelektrode sicher abdeckt und wenn ein üblicher photolithographischer Maskenverfahrensschritt zur Definition der Elektrodenstruktur verwendet wird.

Fign. 2 bis 5 Querschnittsansichten eines Halbleitersubstrats in verschiedenen Stufen des der Erfindung zugrunde liegenden Herstellungsverfahrens; dabei zeigt insbesondere

Fig. 2 einen teilweise fertiggestellten V—MOS-Transistor,

Fig. 3 diesen Transistor nach Aufbringen einer selbstausgleichenden, als erste Maske dienenden Photolackschicht,

Fig. 4 den Transistor nach teilweisem Entfernen der Photolackschicht,

Fig. 5 den gleichen Transistor nach selektivem Abätzen der leitenden Schicht unter Verwendung des verbleibenden Photolacks als Maske,

Fig. 6 eine Draufsicht auf einen V—MOSFET, bei dem ein Teil der leitenden Schicht durch das in den Fign. 2 bis 5 dargestellte selbstausrichtende Verfahren definiert ist, und bei dem, gemäß dem Verfahren der Erfindung, ein anderer Teil der leitenden Schicht mit Hilfe einer zweiten Maske erzeugt ist,

Fig. 7 eine Querschnittsansicht, der in Fig. 6 gezeigten Vorrichtung längs der Linie 7—7 zur Darstellung der Selbstausrichtung eines Teils der leitenden Schicht in Bezug auf die V-förmige Vertiefung und

Fig. 8 eine Querschnittsansicht einer weiteren Ausführungsform mit einer rechteckigen Vertiefung zur Darstellung eines selbstausgerichteten Substratkontaktes mit einer effektiv vergrößerten Fläche gegenüber der eines planaren Kontaktes.

Beschreibung der bevorzugten Ausführungsform

Fig. 2 zeigt eine teilweise fertiggestellte V—MOSFET Vorrichtung mit beispielsweise einem leicht P-dotierten Siliciumsubstrat 10. Hochdotierte N-leitende Zonen 14 und 16 können durch Festkörperdiffusion durch eine in der dielektrischen Schicht 12, die vorzugsweise aus Siliciumdioxid besteht, angebrachten Bohrung hergestellt sein. Durch die gleiche Bohrung in der Schicht 12 wird ein anisotropes Ätzmittel, wie z. B. Hydrazin und Wasser zum Einätzen einer V-förmigen Vertiefung in die obere Oberfläche des Substrats 10 benutzt. Dieses Ätzverfahren ist in einem Aufsatz von M. J. Declercq u. a., mit dem Titel "Optimization of the Hydrozine-Water Solution for Anisotropic Etching of Silicon in the Integrates Circuit Technology" in dem *Journal of Electrochemical Society*, Band 122, Nr. 4, April 1975, auf Seiten 545 bis 552 beschrieben. Wenn die Oberfläche des Substrats 10 parallel zu der 100-Kristallebene geschnitten ist, dann verlaufen die Seitenwände der V-förmigen Vertiefung parallel zur 111-Ebene und bilden mit der 100-Ebene einen Winkel von etwa 54,70. Wenn man Verfahren weiterlaufen läßt, dann hört die Ätzung der V-förmigen Vertiefung von selbst auf und hat die dargestellte Form. Nach Bildung der V-förmigen Vertiefung wird eine dünne, thermische Oxidschicht 18 auf den freiliegenden Seitenwänden der V-förmigen Vertiefung aufgewachsen und bildet damit eine Gateoxidschicht. Anschließend an die Bildung der Oxidschicht 18 wird eine Schicht 22 aus einem leitenden, eine Elektrode bildendem Material, wie z. B. Aluminium oder Polysilicium durch bekannte Verfahren niedergeschlagen. Für die verschiedenen Herstellungsverfahren für unterschiedliche Arten von mit V-förmigen Nuten versehen Halbleitervorrichtungen sei beispielsweise auf die US-Patentschrift 4 065 783 verwiesen sowie auf den Aufsatz "VMOS, A New MOS Integrated Circuit Technology" von F. E. Holmes u. a., in *Solid-State Electronics*, Band 17, Seiten 791 bis 797 oder den zuvor erwähnten Artikel aus *Electronics*.

Obgleich eine vereinfachte MOSFET-Vorrichtung hier beschrieben wird, ist es dem Fachmann doch ohne weiteres klar, daß jede der vielen bischer bekannten, mit V-förmigen Vertiefungen versehenen Strukturen von Halbleitervorrichtungen nach dem erfindungsgemäßen Verfahren hergestellt werden können.

Nach Aufbringen der leitenden Schicht 22, wird gemäß Fig. 3 eine Schicht 24 aus einem eine Maske bildenden Material, wie z. B. einem Photolack aufgebracht, der nicht nur die Oberfläche des Substrats vollständig überdeckt, sondern auch die V-förmigen Vertiefungen ausfüllt und damit eine im wesentlichen ebene Oberfläche liefert. Obgleich viele Materialien bekannt sind, die bei der Herstellung von Halbleitervorrichtungen benutzt werden können, wird doch hier vorzugsweise eine Photolack der Firma Shipley Company, Newton, Massachusetts, mit der Bezeichnung AZ1350J, benutzt. Die Photolackschicht 24, kann beispielsweise dadurch auf der Oberfläche des Substrats angebracht werden, daß sie aufgegossen und dann bei 5000 Umdrehungen/min. geschleudert wird, so daß sie ohne die Tiefe der V-förmigen Vertiefung eine Dicke von etwa 0,6 μm erhält. Nach Aufbringen der Photolackschicht wird das Substrat zum Austreiben der Lösungsmittels und zum Aushärten des Photolacks für 20 Minuten auf etwa 90°C erhitzt.

Anschließend wird gemäß Fig. 4 der obere Teil der Photolackschicht 24 durch ein für den Photolack selektives Ätzverfahren entfernt. Ein bevorzugtes Verfahren besteht darin, die Oberfläche insgesamt einer Belichtung durch ultraviolettes Licht, ohne Verwendung einer Maske, auszusetzen. Dadurch wird der Photolack in einem üblichen alkalischen AZ-Entwickler lösbar, der im Verhältnis 5:4 mit Wasser verdünnt werden kann, wodurch die Entwicklungsgeschwindigkeit auf einen Wert verringert wird, der eine visuelle Bestimmung des Haltepunktes zuläßt. Entwicklungszeiten von 1 bis 3 Minuten sind erwünscht. Da die Entfernung nur eines Teils der Photolackschicht 24 nicht von selbst anhaltend ist, muß eine Art der Überwachung vorgesehen sein, um die Entwicklung an einem Punkt anzuhalten, wenn die Oberfläche der leitenden Schicht 22 freigelegt ist. Eine visuelle Beobachtung ist dabei geeignet, doch man kann auch genauere optische Überwachungsverfahren einsetzten, wie sie derzeit bei der Herstellung von Halbleitervorrichtungen benutzt werden.

Nach dem Ätzen oder Entfernen des größten Teils der Photolackschicht 24, wird das Substrat mit der verbleibenden Photolackschicht für etwa 30 Minuten auf 130°C erhitzt, wodurch die Photolackschicht weiter aushärtet. Anschließend wird ein geeignetes Ätzmittel, das nur das Material der leitenden Schicht 22 angreift, zum Entfernen der gesamten leitenden Schicht 22 benützt, mit Ausnahme an der Stelle, wo die Photolackschicht 24 erhalten geblieben ist, wie dies Fig. 5 zeigt.

Anschließend wird die verbleibende Photolackschicht in üblicher Weise durch ein nasses oder trockenes Ätzverfahren abgezogen.

Bei dem bisher geschilderten Verfahren ist insbesondere dann, wenn der Endpunkt der Entfernung eines Teils der Photolackschicht visuell bestimmt werden soll, wünschenswert, zunächst die Photolackschicht ausschließlich der Tiefe der V-förmigen Nuten mit einer solchen Dicke aufzubringen, daß der zu entfernende Teil dünner ist, als die in den V-förmigen Vertiefungen liegende Schicht, die beibehalten werden soll. In dem hier beschriebenen Verfahren war die Tiefe der V-förmigen Vertiefungen etwa 2 μm. Die Dicke der Photolackschicht 24 liegt dann vorzugsweise bei 0,6 μm. Die relative Dicke des zu entfernenden Materals in bezug auf das verbleibende Material in Verbindung mit einem verdünnten Entwickler erfordert eine weniger kritische Bestimmung des Endpunktes.

Fign. 6 und 7 Veranschenlichen die Verwendung der gemäß der Erfindung einpestaten zweiten (Sparr.) Moske, die nicht selbstjustierend ist und vor Allou zur Herstellung der notwendrpen, an sich unkritischen Elektrodenonschlisse dienen konn. Fig. 6 zeigt dabei eine Draufsicht auf ein Halbleitersubstrat mit einer auf seiner Oberfläche liegenden leitenden Elektrode 26, die einen ersten selbst ausgerichteten Abschnitt 28 innerhalb einer V-förmigen Vertiefung und einen zweiten Abschnitt aufweist, der teilweise innerhalb der V-förmigen Vertiefung und teilweise auf der ebenen Oberfläche des Substrats liegt. Zum Herstellen der Vorrichtung von Fig. 6 werden zunochst die anhand der Fign. 2 bis 5 beschriebenen Verfahrensschnitte benutet, mit der Ausnahme, daß vor dem Ätzen der leitenden Schicht eine unkritische Sperrmaske (nicht gezeigt) vorgesehen ist, die diejenigen Bereiche der leitenden Schicht bedeckt, die beibehalten werden sollen. Diese Maske kann eine weitere Photolackschicht sein, die beispielsweise über dem oberen Abschnitt 26 der in Fig. 6 gezeigten leitenden Schicht aufgebracht ist. Wird das gleiche Photolackmaterial auch für die Sperrmaske benutzt, wie es für die ursprüngliche selbstrausrichtende Maske verwendet wurde, dann kann ein Aushärten der ersten Photolackschicht erforderlich sein, um zu verhindern, daß der restliche Teil der Photolackschicht 24 aufgelöst wird. Im nachfolgenden. Ätzschnitt werden ous der leitenden Schicht 22 die eipantliche, selbstousgerichtete Elektrode 28 und das unit ihr verbundene Verbindungsstück 26 gebildet.

Fig. 7 zeigt eine Schnittansicht längs der Linie 7—7, in Fig. 6, mit der selbstrausgerichteten leitenden Schicht 28 innerhalb der V-förmigen Vertiefung. Die in Fign. 6 und 7 dargestellte Struktur, die einen MOS Kondensator darstellt, könnte an sich jede bekannte mit V-förmiger Vertiefung versehene Halbleitervorrichtung sein.

Fig. 8 zeigt eine weitere Ausführungsform der Erfindung mit einer Vertiefung oder Nut, mit im wesentlichen senkrechten Seitenwänden in Verbindung mit dem oben beschriebenen Verfahren. Hier weist das Halbleitersubstrat 10 eine rechtwinklige Vertiefung oder Nut auf, die entweder durch Zersteubungsätzen oder durch ein anderes, richtungsabhängiges Ätzverfahren einschließlich einer anisotropen Ätzung hergestellt werden kann, vorausgesetzt, daß die richtige ursprüngliche Orientierung der Oberfläche des Substrats eingehalten wird. Hier ist eine selbstausgerichtete Elektrode vorgesehen, die einen Kontakt für das Substrat 10 darstellt.

Es sei noch anzufügen, daß die leitende Schicht nicht nur aus Aluminium oder Polysilicium, sondern auch aus verschiedenen anderen leitenden Materialien gebildet werden kann und daß andere Verfahren, wie z. B. substraktives Ätzen oder Ablöseverfahren zur ursprünglichen Definition der leitenden Schicht verwendet werden können. Wie in den Fign. 7 und 8 angedeutet, kann die in dem Substrat vorgesehene Vertiefung die unterschiedlichsten Formen annehmen, und es ist nicht unbedingt erforderlich, daß in dieser Vertiefung vor dem Aufbringen der leitenden Schicht, eine dielektrische Schicht angebracht wird.

### Patentansprüche

1. Verfahren zum Herstellen einer leitenden Elektrode für eine Halbleitervorrichtung mit einem Substrat (10), in dessen einer Oberfläche mindestens eine Vertiefung angebracht ist, das darin besteht,

dass zunächst eine praktisch gleichförmige Schicht eines eine elektrode bildenden Materials (22) über mindestens einem Teil dieser Oberfläche einschliesslich der Vertiefung niedergeschlagen wird,

dass anschliessend darüber eine Schicht (24) eines eine erste Maske bildenden organischen Materials mit einer solchen Dicke aufgebracht wird, dass eine im wesentlichen ebene Oberfläche entsteht,

dass das Substrat zum Aushärten des die erste Maske bildenden organischen Materials erhitzt wird,

dass anschliessend das die erste Maske bildende organische Material bevorzugt gegenüber dem die elektrode bildenden Material bis unterhalb der Ebene der Substratoberfläche selektiv abgeätzt wird, wodurch selektiv der ausserhalb der Vertiefung liegende Teil des die Elektrode bildenden Materials freigelegt wird,

dass eine zweite, einen Teil der freigelegten Oberfläche des die Elektrode bildenden Materials bedeckende Maske aufgebracht wird, die sich zumindest über einen Teil der Vertiefung und der angrenzenden horizontalen Oberfläche erstreckt,

dass dann selektiv und bevorzugt gegenüber dem die erste und die zweite Maske bildenden Material das die Elektrode bildende Material abgeäzt wird,

wodurch eine Elektrode auf dem Substrat geformt wird, die einen ersten, innerhalb der Vertiefung und unterhalb der Oberfläche des Substrats liegenden Teil (28) und einen zweiten, mit dem ersten verbundenen Teil (26) auf der Substratoberfläche aufweist, und

dass abschliessend die beiden Masken entfernt werden.

2. Verfahren nach Anspruch 1, dadurch gekennzeichnet, dass die Vertiefung durch ein richtungsabhängiges Aetzverfahren hergestellt wird.

3. Verfahren nach Anspruch 1, dadurch gekennzeichnet, dass ein anisotropes Aetzverfahren angewandt wird.

4. Verfahren nach Anspruch 3, dadurch gekennzeichnet, dass eine im wesentlichen V-förmige Vertiefung erzeugt wird.

5. Verfahren nach Anspruch 2, dadurch gekennzeichnet, dass eine im wesentlichen rechteckige Vertiefung erzeugt wird.

6. Verfahren nach Anspruch 5, dadurch gekennzeichnet, dass diese Vertiefung durch Zerstäubungsätzen erzeugt wird.

7. Verfahren nach Anspruch 1, dadurch gekennzeichnet, dass als die Elektrode bildendes Material ein Metall oder polykristallines Silicium verwendet wird.

8. Verfahren nach Anspruch 1, bei dem das Substrat (10) eines vorbestimmten Leitungstyps zuerst mit einer ersten dielektrischen Schicht (12) überzogen wird, in der dann mindestens eine Oeffnung angebracht wird, in der dann ein Teil der Substratoberfläche freigelegt wird, dadurch gekennzeichnet, dass die Vertiefung anisotrop in dem freiliegenden Teil der Substratoberfläche eingeätzt wird, und dass dann innerhalb dieser Vertiefung eine zweite dielektrische Schicht (18) niedergeschlagen wird.

### Revendications

1. Procédé de fabrication d'une électrode conductrice pour un dispositif à semi-conducteurs comportant un substrat (10) dans une face duquel est formé au moins un creux, qui consiste en ce que l'on dépose d'abord une couche pratiquement uniforme d'une matière (22) constituant une électrode sur au moins une partie de cette surface, y compris le creux, on applique ensuite sur elle une couche (24) d'une matière organique constituant un premier masque à une épaisseur telle qu'il se forme une surface supérieure sensiblement plane, on chauffe le substrat pour le durcissement de la matière organique constituant le premier masque, on enlève ensuite sélectivement par corrosion la matière organique constituant le premier masque, de préférence en face de la matière constituant l'électrode, jusqu'au-dessous du plan de la surface du substrat, ce qui dégage sélectivement la partie de la matière constituant l'électrode située en dehors du creux, on applique un second masque recouvrant une partie de la surface dégagée de la matière constituant l'électrode, qui s'étend au moins sur une partie du creux et de la surface horizontale contigüe, on enlève ensuite par corrosion sélectivement et, de préférence, en face de la matière constituant le premier masque et le second masque, la matière constituant l'électrode, de sorte qu'il se forme sur le substrat une électrode qui comporte une première partie partie (28) située à l'intérieur du creux et au-dessous de la surface du substrat et une seconde partie (26) reliée à la première partie, à la surface du substrat, et l'on retire finalement les deux masques.

2. Procédé selon la revendication 1, caractérisé en ce qu'on produit le creux par un procédé de corrosion directionnel.

3. Procédé selon la revendication 1, caractérisé en ce qu'on applique un procédé de corrosion anisotrope.

4. Procédé selon la revendication 3, caractérisé en ce qu'on produit un creux sensiblement en V.

5. Procédé selon la revendication 2, caractérisé en ce qu'on produit un creux sensiblement rectangulaire.

6. Procédé selon la revendication 5, caractérisé en ce qu'on produit ce creux par corrosion par pulverisation.

7. Procédé selon la revendication 1, caractérisé en ce qu'on utilise, comme matière constituant l'électrode, un métal ou du silicium polycristallin.

8. Procédé selon la revendication 1, dans lequel on recouvre le substrat (10) d'un type de conductivité prédéterminé, d'abord d'une première couche diélectrique (12), dans laquelle on mélange alors au moins une ouverture, dans laquelle alors une partie de la surface du substrat est dégagée, caractérisé en ce qu'on forme le creux par corrosion anisotrope dans la partie dégagée de la surface du substrat, et en ce qu'on dépose alors à l'intérieur de ce creux une second couche diélectrique (18).

## Claims

1. Method of producing a conducting electrode for a semiconductor device with a substrate (10) having, in a surface thereof, at least one recess, the method comprising the steps of:

depositing a substantially uniform layer of an electrode forming material (22) over at least part of said surface, including said recess,

depositing a layer (24) of an organic material forming a first mask of such thickness that a substantially planar surface is obtained,

heating the substrate for hardening the organic material forming said first mask,

selectively etching the organic material forming said first mask in preference to the electrode forming material to a depth below the level of the substrate surface to selectively expose that part of the electrode forming material outside said recess,

depositing a second mask covering a part of the exposed surface of the electrode forming material, said second mask extending over at least part of said recess and the adjacent horizontal surface,

selectively etching the electrode forming material in preference to the materials forming said first and said second mask, whereby an electrode is formed on the substrate consisting of a first part (28) within said recess and below the substrate surface and a second part (26) connected to said first part and located on the substrate surface, and removing said two masks.

2. Method as in claim 1, characterized in that said recess is formed using a directionally dependent etching process.

3. Method as in claim 1, characterized in that an anisotropic etching process is used.

4. Method as in claim 3, characterized in that said recess is substantially V-shaped in cross-section.

5. Method as in claim 2, characterized in that said recess is substantially rectangular in cross-section.

6. Method as in claim 5, characterized in that said recess is provided by sputter etching.

7. Method as in claim 1, characterized in that said electrode forming material is a metal or polycrystalline silicon.

8. Method as in claim 1, wherein the substrate (10) of a predetermined conductivity type is first covered with a dielectric layer (12) in which at least one opening is provided to expose a region of the substrate surface, characterized in that the recess is anisotropically etched in the exposed part of the substrate surface and that, subsequently, a second dielectric layer (18) is deposited within said recess.

FIG. 1

FIG. 2

FIG. 3

FIG. 4

FIG. 5

FIG. 6

FIG. 7

FIG. 8